# EUROPEAN PATENT APPLICATION

(11) **EP 4 524 605 A1**
(43) Date of publication of application: **19.03.2025**
(21) Application number: 23197685.3
(22) Date of filing: 15.09.2023
(51) Int. Cl.: G01S 7/40, G01S 7/497, G01S 7/52, G01S 13/89, G01S 13/931, G01S 15/931, G01S 17/931, G01S 17/89

(54) **METHOD FOR POSITIONING A PERCEPTION SENSOR ON A VEHICLE**

(71) Applicant: Aptiv Technologies AG, 8200 Schaffhausen (CH)
(72) Inventor: Talai, Armin, 90431 Nürnberg (DE); Leonardi, Roberto, 90403 Nürnberg (DE); Vinci, Gabor, 90763 Fürth (DE); Kalli, Sashi Praveen, 42899 Remscheid (DE)
(74) Representative: Manitz Finsterwald Patent- und Rechtsanwaltspartnerschaft mbB

(57) **Abstract**

A method is provided for positioning a perception sensor on a vehicle. A three-dimensional coverage map of the perception sensor is determined, and vehicle specific geometry characteristics are received. A coverage region for the perception sensor in a vicinity of the vehicle is estimated by combining the vehicle specific geometry characteristics and the three-dimensional coverage map of the perception sensor and by varying a spatial location of the perception sensor until the coverage region in the vicinity of the vehicle is optimized.

## Description

### FIELD

The present disclosure relates to a computer implemented method for positioning a perception sensor on a vehicle.

### BACKGROUND

For performing specific maneuvers of a vehicle, it is mandatory that the external environment of the vehicle is monitored in its entirety in a proper manner. For monitoring the external environment of a vehicle, perception sensors like radar systems, Lidar systems or cameras are used. If an autonomous parking application is to be performed, for example, it is necessary to provide the physical evidence for the feasibility of such an application which may be accomplished by a radar system covering close and far distances with respect to the vehicle.

For known radar systems, two-dimensional coverage maps are usually generated in which certain tolerances regarding the spatial installation location of a radar sensor are considered, e.g. tolerances of roll, pitch and yaw angles of the radar sensor. Such two-dimensional coverage maps properly cover large distances with respect to the vehicle and may be suitable for applications requiring such large distances with respect to the vehicle only.

However, the known two-dimensional coverage maps for radar sensors installed in a vehicle do not provide information for ultra-short distances which may be required for low-speed and parking applications. Moreover, the known two-dimensional coverage maps do not consider vehicle-specific design features. Due to a specific installation of a radar sensor on a vehicle, vehicle components may cause shadowing effects for the radar sensor which cannot be identified by the known two-dimensional coverage maps. In addition, the effects of a specific mounting height of the radar sensor on the spatial coverage of the radar sensor under consideration is usually not included in the two-dimensional coverage maps. Hence, by using the known coverage maps, it is mostly not possible to perform a proper radar integration such that the radar system is suitable for supporting autonomous parking applications, for example.

Accordingly, there is a need to have a method for integrating a perception sensor in a vehicle such that the perception sensor is able to support low speed applications and autonomous parking applications of the vehicle.

### SUMMARY

The present disclosure provides a computer implemented method, a computer system and a non-transitory computer readable medium according to the independent claims. Embodiments are given in the subclaims, the description and the drawings.

In one aspect, the present disclosure is directed at a computer implemented method for positioning a perception sensor on a vehicle. According to the method, a three-dimensional coverage map of the perception sensor is determined, and vehicle specific geometry characteristics are received. A coverage region for the perception sensor in a vicinity of the vehicle is estimated by combining the vehicle specific geometry characteristics and the three-dimensional coverage map of the perception sensor and by varying a spatial location of the perception sensor until the coverage region in the vicinity of the vehicle is optimized.

The three-dimensional coverage map may first be determined independently from a specific vehicle or vehicle line and scaled thereafter to vehicle coordinates. If the perception sensor includes a radar sensor, for example, a target range coverage for a radar cross-section (RCS) of -15 dBsm (decibels per square meter) may be considered for the external environment of the sensor when determining the three-dimensional coverage map.

In addition to or as an alternative to a radar sensor, the perception sensor may also include a Lidar sensor or a camera system. Hence, an instrumental field of view of the perception sensor may also be considered when determining the three-dimensional coverage map.

The vehicle specific geometry characteristics may be provided e.g. by CAD data related to the outer contour of the vehicle. The CAD data may also be considered when scaling the three-dimensional coverage map with respect to the specific vehicle or vehicle line.

Optimizing the coverage region may include that the coverage of the perception sensor is maximized in a desired predefined area or volume in the proximity of the vehicle, i.e. such that so-called blind volumes being not covered may be minimized, while the coverage of the perception sensor may be reduced in other areas or volumes outside of the desired predefined area or volume. The desired predefined area or volume may depend on the specific applications in which the perception sensor is to be involved, e.g. specific low speed and/or parking applications.

One advantage of the method is the possibility to determine coverage maps in close proximity of a vehicle which may represent a specific vehicle line. Hence, the spatial location of the perception sensor on the vehicle may be optimized via the coverage maps for the close proximity of the vehicle such that low-speed scenarios and parking applications may be properly supported. The spatial location to be varied may include a position, i.e. longitudinal and lateral coordinates of the perception sensor with respect to a vehicle coordinate system and its mounting height with respect to a ground level, and an angle orientation including yaw, pitch and roll angles.

In an early stage of a vehicle design, the method may further enable the planning of parking configurations based on a suitable spatial location of the perception sensor. Conversely, spots or regions having a weak or low coverage may be identified for a specific vehicle line via the method, and the effectivity of a compensation of such areas or regions having low coverage e.g. by an additional perception sensor may be assessed. For example, if an entire perception system includes a plurality of radar sensors, an integration scenario of these radar sensors may be optimized via unified coverage maps provided by the method.

According to an embodiment, varying the spatial location of the perception sensor may include varying a positioning height of the perception sensor with respect to a ground level and varying a yaw angle, a pitch angle and a roll angle of the perception sensor with respect to the vehicle. The yaw angle, the pitch angle and the roll angle may be defined with respect to a vehicle coordinate system having its origin at a center of gravity of the vehicle, for example, and having one axis aligned with a longitudinal axis of the vehicle.

For this embodiment, the positioning or mounting height of the perception sensor may be varied only while the longitudinal and lateral coordinates of the perception sensor with respect to the vehicle may be fixed. Alternatively, the longitudinal and lateral coordinates of the perception sensor with respect to the vehicle may also be varied in order to optimize the coverage region.

Due to the variation of the positioning height and the orientation, i.e. the angles of the perception sensor, in order to optimize the coverage region in the vicinity of the vehicle, the method may result in an optimized spatial location of the perception sensor in terms of the positioning height and the yaw, pitch and roll angles of the perception sensor. For example, the coverage region may be maximized in the proximity of the vehicle close to the optimized spatial location of the perception sensor such that low speed and parking applications may be properly supported by the perception sensor being located at the optimized spatial location.

According to a further embodiment, the perception sensor may include a radar sensor, and determining the three-dimensional coverage map may include applying link budget equations and a predefined radar cross-section. Due to this framework for determining the three-dimensional coverage map, a low computational effort may be required for performing the method.

The optimized coverage region may be determined by using a predetermined basic frequency of the radar sensor in order to determine an optimized spatial location of the radar sensor. Furthermore, a respective three-dimensional coverage map may be determined for each of a predefined number of frequencies of the radar sensor being different from the basic frequency. A respective coverage region of the radar sensor may be estimated in vicinity of the vehicle for each of the predefined number of frequencies for the optimized spatial location of the radar sensor by applying the respective three-dimensional coverage map.

The basic frequency may be 77 GHz for example, and the further frequencies being different from the basic frequency may include a predefined number of frequencies in the range between e.g. 76 GHz and 81 GHz. Determining respective further coverage regions of the perception sensor at different frequencies for the optimized spatial location of the radar sensor may allow to analyze whether a specific target in the vicinity of the vehicle can be detected at all frequencies of the frequency range defining the predefined number of frequencies. This may be relevant for a radar sensor emitting radar waves at frequencies of a quite broad range. Moreover, it may be determined whether such a radar sensor allows for detecting a specific target in the vicinity of the vehicle within a certain frequency range only which may be smaller than the frequency range of the emitting radar sensor.

The vehicle specific geometry characteristics may include a CAD model of the vehicle (CAD from computer added design). Hence, the vehicle specific geometry characteristics may be provided in a standardized format based on CAD which may reduce the effort for receiving the vehicle specific geometry characteristics for the method.

Shadowed areas located in predefined region of interest outside of the coverage region may be determined by considering geometries provided by the CAD model of the vehicle. The shadowed areas may be defined as such areas which are located at the ground level, for example, and which are not covered or illuminated by the perception sensor due to a line-of-sight with respect to the perception sensor being blocked by a part of the vehicle. Therefore, the method may be able to assess whether certain areas within the predefined region of interest being relevant e.g. for low speed and parking applications are covered or illuminated by the perception sensor or not. This may support a design phase of the vehicle, e.g. in an early stage, in which specific components of the vehicle may still be flexible regarding their position and/or design, and allow for a modification of the position and/or design such that the shadowed areas may be reduced or even be avoided.

Moreover, at least one blind volume located outside the coverage region may be determined with respect to the CAD model of the vehicle. In addition to the shadowed areas which may be caused by parts or components of the vehicle and which may cause blind volumes, at least one further blind volume may be determined which may be caused by the spatial location of the perception sensor itself. Hence, it may be possible to alter the spatial location of the perception sensor generally such that the at least one blind volume may be properly reduced or even completely avoided.

In another aspect, the present disclosure is directed at a computer system, said computer system being configured to carry out several or all steps of the computer implemented method described herein.

The computer system may comprise a processing unit, at least one memory unit and at least one non-transitory data storage. The non-transitory data storage and/or the memory unit may comprise a computer program for instructing the computer to perform several or all steps or aspects of the computer implemented method described herein.

As used herein, terms like processing unit and module may refer to, be part of, or include an Application Specific Integrated Circuit (ASIC), an electronic circuit, a combinational logic circuit, a Field Programmable Gate Array (FPGA), a processor (shared, dedicated, or group) that executes code, other suitable components that provide the described functionality, or a combination of some or all of the above, such as in a system-on-chip. The processing unit may include memory (shared, dedicated, or group) that stores code executed by the processor.

In another aspect, the present disclosure is directed at a vehicle including a perception system having at least one perception sensor, wherein the spatial location of the perception sensor with respect to the vehicle has been determined by performing the method as described above.

As such, the perception system of the vehicle relies on a perception sensor having a spatial location being optimized by performing the method steps as described above. Therefore, the benefits, the advantages and the disclosure for the method are also valid for the vehicle according to the disclosure.

According to an embodiment, the spatial location or position of the at least one perception sensor has been determined such that at least one blind volume inside a required coverage region or region of interest of the perception sensor may be optimized at the vehicle. In other words, blind volumes at the vehicle may be optimized or minimized with respect to a specific application like a parking or low speed application in a desired predefined region in the close vicinity of the vehicle. In this manner, it may be assured that the vehicle may be able to perform the specific application.

The perception system may include at least two perception sensors which may have an overlapping three-dimensional coverage region. Within such an overlapping three-dimensional coverage region, a specific target may be visible for more than one perception sensor. By this means, the confidence for detecting a specific target may be increased.

According to a further embodiment, the perception system of the vehicle may include a radar system comprising at least one radar sensor. The radar system may include at least one front radar sensor, at least one radar sensor positioned at a side of the vehicle, and at least one rear radar sensor. For such a vehicle having at least three radar sensors, the respective spatial location for each of the radar sensors may be varied according to the method as described above such that the shadowed areas and/or any blind volumes around the vehicle may be optimized for the specific group of radar sensors in their entirety. Hence, the vehicle may be optimized for specific applications like low speed and parking applications by optimizing the spatial location of all radar sensors together.

Additionally or alternatively, the perception system may include a Lidar system comprising at least one Lidar sensor. For such a Lidar sensor, the method according to the disclosure may also be performed in a similar manner as described above for a radar sensor. If the Lidar sensor is installed in addition to a radar sensor, the reliability of the perception system may be improved when detecting a specific target in the close vicinity of the vehicle.

In another aspect, the present disclosure is directed at a non-transitory computer readable medium comprising instructions for carrying out several or all steps or aspects of the computer implemented method described herein. The computer readable medium may be configured as: an optical medium, such as a compact disc (CD) or a digital versatile disk (DVD); a magnetic medium, such as a hard disk drive (HDD); a solid state drive (SSD); a read only memory (ROM); a flash memory; or the like. Furthermore, the computer readable medium may be configured as a data storage that is accessible via a data connection, such as an internet connection. The computer readable medium may, for example, be an online data repository or a cloud storage.

The present disclosure is also directed at a computer program for instructing a computer to perform several or all steps or aspects of the computer implemented method described herein.

### DRAWINGS

Exemplary embodiments and functions of the present disclosure are described herein in conjunction with the following drawings, showing schematically:
- Fig. 1: an illustration of a coverage map of a radar sensor and of the scaling of the coverage map,
- Fig. 2: an illustration of determining a coverage region for the radar sensor in the close vicinity of a vehicle,
- Fig. 3: a three-dimensional illustration of an optimization of blind volumes at a specific vehicle,
- Fig. 4: a detailed two-dimensional plan view of respective coverage regions and blind volumes for a plurality of radar sensors installed at a vehicle,
- Fig. 5: a flow diagram illustrating a method for positioning a perception sensor on a vehicle according to various embodiments,
- Fig. 6: an illustration of a system according to various embodiments, and
- Fig. 7: a computer system with a plurality of computer hardware components configured to carry out steps of a computer implemented method as described herein.

### DETAILED DESCRIPTION

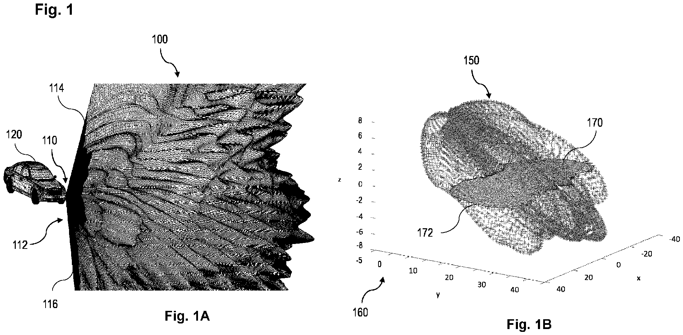

Fig. 1A depicts a three-dimensional coverage map 100 which is determined for a radar sensor 110 as a first step of a method according to the disclosure. The coverage map 100 is a three-dimensional spherical map which is estimated based on link budget equations considering a predefined target radar cross-section. For example, a target having a radar cross-section (RCS) of -15 dBsm corresponding e.g. to a curb stone may be assumed. The three-dimensional coverage map 100 is estimated with respect to a predetermined signal-to-noise ratio of a radar sensor and a minimum required signal-to-noise ratio which may be given by a swirling model.

The radar sensor 110 has a predefined instrumental field of view 112 including boundaries which are indicated by the lines 114 and 116 in Fig. 1A. In addition, a vehicle 120 is shown in order to illustrate that the radar sensor 110 may be used as a corner radar sensor in the front region of the vehicle 120.

As a next step of the method according to the disclosure, a scaled three-dimensional CAD model is generated for the coverage map 100 as provided in Fig. 1A. By using e.g. MATLAB, a surface mesh 150 which is shown in Fig. 1B is generated for the three-dimensional coverage map 100. The surface mesh 150 is represented by the crosses and is depicted with respect to a coordinate system 160. Since a mounting height of the radar sensor 110 with respect to a ground level is known, an illuminated surface 170 at the ground level can be determined which is shown within a boundary or contour 172 within a plane at z = 0. Hence, the illuminated surface 170 is covered by the radar waves which are transmitted by the radar sensor 110. Furthermore, the mathematical representation of the illuminated surface 170 may be exported as surface or a polygon representing the contour 172 of the illuminated surface 107 e.g. out of MATLAB for further processing by other applications.

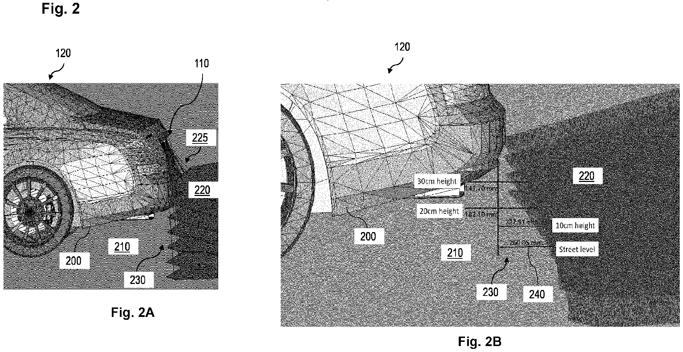

As a next step of the method according to the disclosure, vehicle specific geometry characteristics are received in form of a CAD model 200 of the vehicle 120. The CAD model 200 of the vehicle 120 is shown in Figs. 2 to 4 as a line mesh including polygons which represent the different components at an outer surface of the vehicle 120. In Fig. 2A, a rear part of vehicle 120 is shown. In the middle of the rear of the vehicle 120, the radar sensor 110 is mounted at a specific mountain height above a ground level 210. As shown in Fig. 2A, the coverage of the radar waves at -15 dBsm is depicted as a coverage region 220 represented by planes extending in parallel to the ground level 210 and having a respective height distance of 10 cm between each other along a direction perpendicular to the ground level 210.

Polygons are extruded from the position of the radar sensor 110 until most of the outer parts of the vehicle 120 are swept. A projection of the position of the radar sensor is elongated down the road, i.e. to the ground level 210. These projections are shown as lines 225 in Fig. 2A.

As can be seen in Fig. 2A and in more detail in Fig. 2B, shadowed areas 230 are generated on the ground level 210 by certain components of the vehicle 120 which prevent the radar waves transmitted by the radar sensor 110 from arriving at the ground level 210. Such shadowing effects of the vehicle components cause a blind distance of about 260 mm behind the vehicle 120 on the ground level 210. In addition, a respective blind distance is shown for different target heights above the ground level 210 in steps of 10 cm. At a target height of 30 cm, the blind distance reduces to about 141 mm.

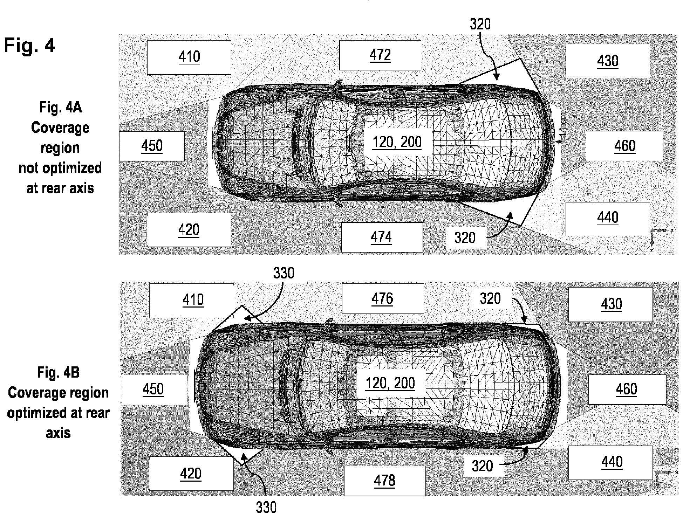

As a further step of the method according to the disclosure, a coverage region is estimated for the radar sensor 110 in the vicinity of the vehicle 120 by combining the vehicle specific geometry characteristics, i.e. the CAD model 200 provided for the vehicle 120, and the three-dimensional coverage map 100 of the radar sensor 110. The three-dimensional coverage map is provided in form of the surface mesh 150 as shown in Fig. 1B. The coverage region for the radar sensor 110 includes a three-dimensional volume which is illustrated, for example, by the parallel planes 220 in Fig. 2 which are depicted as layers at different heights with respect to the ground level 210. Moreover, coverage regions 410 to 478 are also depicted in Fig. 4 for different radar sensors installed on the vehicle 120 as a plan view for a height of 30 cm with respect to the ground level 210.

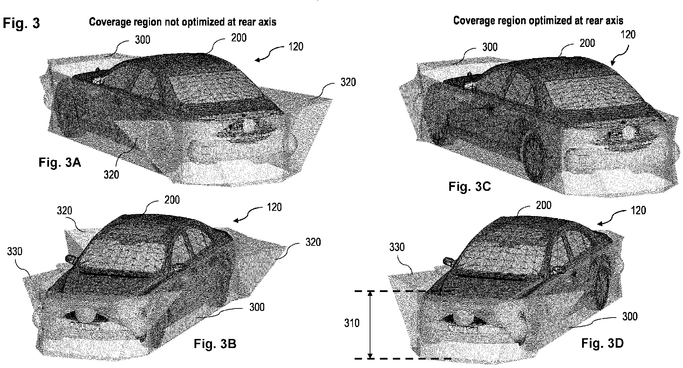

As a further step of the method according to the disclosure, a spatial location of the radar sensor 110 is varied until the coverage region in the vicinity of the vehicle 120 is optimized. In the present example, the spatial location of the radar sensor 110 includes a positioning height of the radar sensor 110 with respect to the ground level 210 and a spatial orientation including a yaw angle, a pitch angle and a roll angle of the radar sensor 110 with respect to the vehicle 120. The optimization of coverage region in the close vicinity of the vehicle 120 is illustrated in Figs. 3 and 4.

In Figs. 3A and 3B, a rear view and a front view of the vehicle 120, respectively, are schematically depicted together with a total blind volume 300 of the radar sensors being installed at different positions on the vehicle 120. The total blind volume 300 is a volume around the vehicle 220 which is not illuminated by any of the radar sensors installed at the vehicle 120. In other words, radar waves transmitted by the radar sensors do not cover the blind volume 300. In Figs. 3A to 3D, the blind volume 300 is depicted up to a height of about 1 m above the ground level 210 (see Fig. 2). This height of about 1 m up to which the bind volume 300 is estimated is illustrated in Fig. 3D by the arrow 310 and the dashed lines. In Fig. 3, the vehicle 120 is represented by the CAD model 200.

For the total blind volume 300 as shown in Figs. 3A and 3B, the spatial location of the radar sensors has not been varied in such a manner that the coverage region 220 (see Fig. 2) is optimized with respect to low speed and parking applications. Therefore, the total blind volume 300 includes quite a large specific blind volume 320 next to a rear axle of the vehicle 120. Hence, the perception system of the vehicle 100 including the radar sensor is blind around the rear wheels of the vehicle 120 which may prevent a proper performance of low speed and parking applications.

For the vehicle 120 as shown in Figs. 3C and 3D, however, the spatial location of the radar sensors installed on the vehicle 120 is varied in such a manner that the coverage region is optimized for the low speed and parking applications close to the rear axle. As can be recognized in Figs. 3C and 3D, the specific blind volume 320 as shown in Figs. 3A and 3B at the rear axle of the vehicle 120 is removed almost completely. However, a specific blind volume 330 at the front axle of the vehicle 120 is increased by the optimization of the coverage region 220 of the radar sensor 110 with respect to the low speed and parking applications. However, this may not prevent a proper performance of these applications.

In detail, the most important difference between the spatial locations of the radar sensors for the vehicle 120 as shown in Figs. 3A and 3B on the one hand and for the vehicle 120 as shown in Figs. 3C and 3D on the other hand refers to the yaw angle of so-called gap-filler radars installed at a side of the vehicle 120. For the vehicle 120 as shown in Figs. 3A and 3B, a yaw angle of 0° has been applied for the gap-filler radar sensor, whereas for the vehicle 120 as shown in Figs. 3C and 3D, the gap-filler radar sensors installed at the sides of the vehicle 120 have had a yaw angle of -20° and +20°, respectively.

The coverage regions 410 to 478 of the respective radar sensors installed on the vehicle 120 are depicted in detail in Fig. 4. Fig. 4A corresponds to the situation as shown in Figs. 3A and 3B for which the entire coverage region of the radar sensors has not been optimized at the rear axle of the vehicle 120 as requested by low speed and parking applications. In contrast, Fig. 4B corresponds to the situation as shown in Figs. 3C and 3D for which the entire coverage region of the radar sensors has been optimized at the rear axle by applying a respective yaw angle of -20° and +20°, respectively, to the gap-filler radar sensors installed at the side of the vehicle 120. In Figs. 4A and 4B, the coverage regions 410 to 478 are shown for a height of 30 cm with respect to ground level. The plane at a height of 30 cm above the ground level 210 is also shown in Fig. 2B. For this plane, a blind distance of about 14 cm is calculated which is also indicated in Fig. 4A.

In detail, a top view of the vehicle and the respective coverage regions provided by the different radar sensors installed on the vehicle 120 is shown in Fig. 4A and Fig. 4B, respectively. For both figures, four main radar sensors are installed at corners of the vehicle 120 at a mounting height of 50 cm. The respective coverage regions of the main radar sensors are indicated by 410, 420, 430 and 440 in Figs. 4A and 4B. The front right radar sensor is installed at a yaw angle of 60°, while to front left radar sensor is installed at a yaw angle of -60°. For the front right and front left radar sensors, the respective coverage regions are denoted by 410 and 420, respectively. In contrast, the rear right radar sensor and rear left radar sensors are installed at a yaw angle of 45° and -45°, respectively. The coverage region of the rear right and rear left radar sensors are denoted by 430 and 440, respectively.

In addition, the coverage region for four gap-filler radar sensors are also shown in Fig. 4A and Fig. 4B. The gap-filler radar sensors are installed at the sides of the vehicle 120 between the main radar sensors being located at the corners of the vehicle 120. The four gap-filler radar sensors are installed at a pitch angle of -45°.

A front gap-filler radar sensor is installed at a mounting height of 70 cm and the corresponding coverage region is denoted by 450. A rear gap-filler radar sensor is installed at a mounting height of 90 cm and its coverage region is denoted by 460.

The gap-filler radar sensors mounted at the side of the vehicle are installed at a mounting height of 100 cm. For the situation as shown in Fig. 4A, the gap-filler radar sensors mounted at the side of the vehicle have a yaw angle of 0°. The respective coverage region of the side gap-filler radar sensors is denoted by 472 and 474, respectively, in Fig. 4A.

In contrast, for the situation as shown in Fig. 4B the side gap-filler radar sensors are installed at a yaw angle of -20° and +20°, respectively. The corresponding coverage regions of these side gap-filler sensors are denoted by 476 and 478, respectively, in Fig. 4B.

As can be recognized in Fig. 4A, a respective blind volume 320 which is represented as a shadowed area at the height of 30 cm with respect to the ground level and which is not covered by any of the radar sensors installed on the vehicle 120 appears close to the rear axle of the vehicle 120. In contrast, the blind volume 320 is strongly reduced by the installation of the radar sensors as shown in Fig. 4B, whereas the blind volumes 330 at the front axle of the vehicle are increased. However, the optimization of the coverage region in the proximity of the rear axle of the vehicle 120 as shown in Fig. 4B allows for a proper performance of low speed and parking applications.

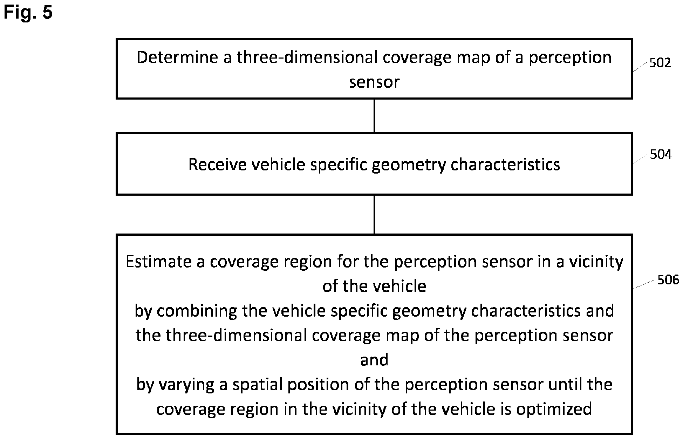

Fig. 5 shows a flow diagram 500 illustrating a method for positioning a perception sensor on a vehicle. At 502, a three-dimensional coverage map of the perception sensor may be determined. At 504, vehicle specific geometry characteristics may be received. At 506, a coverage region for the perception sensor in a vicinity of the vehicle may be estimated by combining the vehicle specific geometry characteristics and the three-dimensional coverage map of the perception sensor and by varying a spatial location of the perception sensor until the coverage region in the vicinity of the vehicle is optimized.

According to various embodiments, varying the spatial location of the perception sensor may include varying a positioning height of the perception sensor with respect to a ground level and varying a yaw angle, a pitch angle and a roll angle of the perception sensor with respect to the vehicle.

According to various embodiments, the perception sensor may include a radar sensor, and determining the three-dimensional coverage map may include applying link budget equations and a predefined radar cross-section.

According to various embodiments, the optimized coverage region may be determined by using a predetermined basic frequency of the radar sensor in order to determine an optimized spatial location of the radar sensor. A respective three-dimensional coverage map may be determined for each of a predefined number of frequencies of the radar sensor being different from the basic frequency, and a respective coverage region of the radar sensor may be estimated in the vicinity of the vehicle for each of the predefined number of frequencies for the optimized spatial location of the radar sensor by applying the respective three-dimensional coverage map.

According to various embodiments, the vehicle specific geometry characteristics may include a CAD model of the vehicle.

According to various embodiments, shadowed areas located in a predefined region of interest outside of the coverage region may be determined by considering the geometries provided by the CAD model of the vehicle.

According to various embodiments, at least one blind volume located outside of the coverage region may be determined with respect to the CAD model of the vehicle.

Each of the steps 502, 504, 506 and the further steps described above may be performed by computer hardware components.

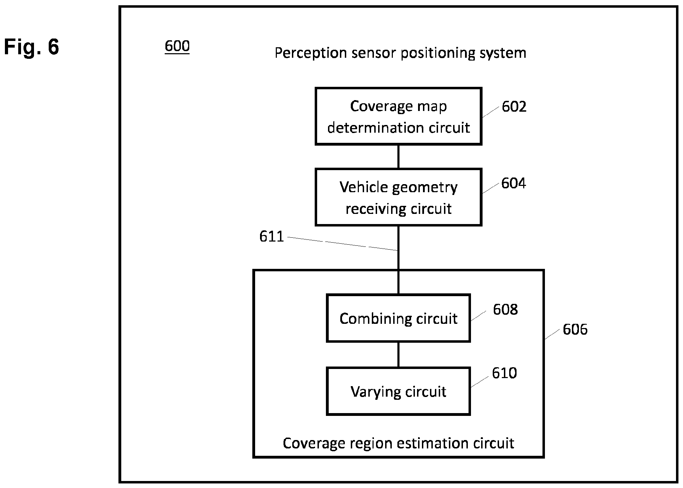

Fig. 6 shows a perception sensor positioning system 600 according to various embodiments. The perception sensor positioning system 600 may include a coverage map determination circuit 602, a vehicle geometry receiving circuit 604, and a coverage region estimation circuit 606 which may include a combining circuit 608 and a varying circuit 610.

The coverage map determination circuit 602 may be configured to determine a three-dimensional coverage map of a perception sensor. The vehicle geometry receiving circuit 604 may be configured to receive vehicle specific geometry characteristics. The coverage region estimation circuit 606 may be configured to estimate a coverage region for the perception sensor in a vicinity of the vehicle by using the combining circuit 608 and the varying circuit 610. The combining circuit 608 may be configured to combine the vehicle specific geometry characteristics and the three-dimensional coverage map of the perception sensor. The varying circuit 610 may be configured to vary a spatial location of the perception sensor until the coverage region in the vicinity of the vehicle is optimized.

The coverage map determination circuit 602, the vehicle geometry receiving circuit 604, the coverage region estimation circuit 606, the combining circuit 608 and the varying circuit 610 may be coupled to each other, e.g. via an electrical connection 611, such as e.g. a cable or a computer bus or via any other suitable electrical connection to exchange electrical signals.

A "circuit" may be understood as any kind of a logic implementing entity, which may be special purpose circuitry or a processor executing a program stored in a memory, firmware, or any combination thereof.

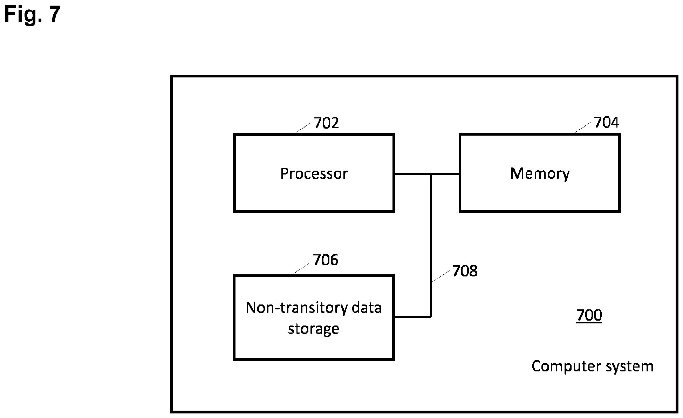

Fig. 7 shows a computer system 700 with a plurality of computer hardware components configured to carry out steps of a computer implemented method for integrating a radar sensor in a vehicle according to various embodiments. The computer system 700 may include a processor 702, a memory 704, and a non-transitory data storage 706.

The processor 702 may carry out instructions provided in the memory 704. The non-transitory data storage 706 may store a computer program, including the instructions that may be transferred to the memory 704 and then executed by the processor 702.

The processor 702, the memory 704, and the non-transitory data storage 706 may be coupled with each other, e.g. via an electrical connection 708, such as e.g. a cable or a computer bus or via any other suitable electrical connection to exchange electrical signals.

As such, the processor 702, the memory 704 and the non-transitory data storage 706 may represent the coverage map determination circuit 602, the vehicle geometry receiving circuit 604, the coverage region estimation circuit 606, the combining circuit 608 and the varying circuit 610, as described above.

The terms "coupling" or "connection" are intended to include a direct "coupling" (for example via a physical link) or direct "connection" as well as an indirect "coupling" or indirect "connection" (for example via a logical link), respectively.

It will be understood that what has been described for one of the methods above may analogously hold true for the perception sensor positioning system 600 and/or for the computer system 700.

### Reference numeral list

- 100: coverage map
- 110: radar sensor
- 112: field of view of the radar sensor
- 114, 116: boundaries of the field of view
- 120: vehicle
- 150: surface mesh of the coverage map
- 160: coordinate system
- 170: illuminated surface at ground level
- 172: contour of the illuminated surface
- 200: CAD model of the vehicle
- 210: ground level
- 220: coverage region
- 225: projection lines
- 230: shadowed area
- 240: blind distance
- 300: total blind volume
- 310: depicted height of the blind volume
- 320: specific blind volume at the rear axle of the vehicle
- 330: specific blind volume at the front axle of the vehicle
- 410 - 440: coverage regions of main radar sensors
- 450: coverage region of front gap-filler radar sensor
- 460: coverage map of rear gap-filler radar sensor
- 472 - 478: coverage regions of radar sensors mounted at a side of the vehicle

- 500: flow diagram illustrating a method for positioning a perception sensor on a vehicle
- 502: step of determining a three-dimensional coverage map of the perception sensor
- 504: step of receiving vehicle specific geometry characteristics

- 506: step of estimating a coverage region for the perception sensor in a vicinity of the vehicle by combining the vehicle specific geometry characteristics and the three-dimensional coverage map of the perception sensor and by varying a spatial location of the perception sensor until the coverage region in the vicinity of the vehicle is optimized

- 600: perception sensor positioning system
- 602: coverage map determination circuit
- 604: vehicle geometry receiving circuit
- 606: coverage region estimation circuit
- 608: combining circuit
- 610: varying circuit
- 611: connection

- 700: computer system
- 702: processor
- 704: memory
- 706: non-transitory data storage
- 708: connection

## Claims

1. Computer implemented method for positioning a perception sensor (110) on a vehicle (120), the method comprising:
determining a three-dimensional coverage map (100) of the perception sensor (110),
receiving vehicle specific geometry characteristics (200),
estimating a coverage region (476, 478) for the perception sensor (110) in a vicinity of the vehicle (120) by combining the vehicle specific geometry characteristics (200) and the three-dimensional coverage map (100) of the perception sensor (110) and by varying a spatial location of the perception sensor (110) until the coverage region (476, 478) in the vicinity of the vehicle (120) is optimized.

2. Method according to claim 1, wherein
varying the spatial location of the perception sensor (110) includes varying a positioning height of the perception sensor (110) with respect to a ground level (210) and varying a yaw angle, a pitch angle and a roll angle of the perception sensor (110) with respect to the vehicle (120).

3. Method according to claim 1 or 2, wherein
the perception sensor (110) includes a radar sensor, and
determining the three-dimensional coverage map (100) includes applying link budget equations and a predefined radar cross-section.

4. Method according to claim 3, wherein
the optimized coverage region (476, 478) is determined by using a predetermined basic frequency of the radar sensor (110) in order to determine an optimized spatial location of the radar sensor (110),
a respective three-dimensional coverage map is determined for each of a predefined number of frequencies of the radar sensor (110) being different from the basic frequency, and
a respective coverage region of the radar sensor (110) is estimated in the vicinity of the vehicle (120) for each of the predefined number of frequencies for the optimized spatial location of the radar sensor (110) by applying the respective three-dimensional coverage map.

5. Method according to any one of claims 1 to 4, wherein
the vehicle specific geometry characteristics (200) include a CAD model of the vehicle (120).

6. Method according to claim 5, wherein
shadowed areas (230) located in a predefined region of interest outside of the coverage region (476, 478) are determined by considering the geometries provided by the CAD model (100) of the vehicle (120).

7. Method according to claim 5 or 6, wherein
at least one blind volume (320) located outside of the coverage region (476, 478) is determined with respect to the CAD model (200) of the vehicle (120).

8. Computer system, the computer system being configured to carry out the computer implemented method of at least one of claims 1 to 7.

9. Vehicle (120) including a perception system having at least one perception sensor (110),
wherein the spatial location of the perception sensor (110) with respect to the vehicle (120) has been determined by performing the method according to any one of claims 1 to 7.

10. Vehicle (120) according to claim 9, wherein
the spatial location of the at least one perception sensor (110) has been determined such that at least one blind volume (320) inside of a required coverage region of the perception sensor (110) is optimized at the vehicle (120).

11. Vehicle (120) according to claim 9 or 10, wherein
the perception system includes at least two perception sensors (110) which have an overlapping three-dimensional coverage region.

12. Vehicle (120) according to any one of claims 9 to 11, wherein
the perception system includes a radar system comprising at least one radar sensor (110).

13. Vehicle (120) according to claim 12, wherein
the radar system includes at least one front radar sensor, at least one radar sensor positioned at a side of the vehicle, and at least one rear radar sensor.

14. Vehicle (120) according to any one of claims 9 to 13, wherein
the perception system includes a Lidar system comprising at least one Lidar sensor.

15. Non-transitory computer readable medium comprising instructions for carrying out the computer implemented method of at least one of claims 1 to 7.
